# EUROPEAN PATENT SPECIFICATION

(11) **EP 2 719 268 B1**
(45) Date of publication and mention of the grant of the patent: **08.04.2015**
(21) Application number: 12748801.3
(22) Date of filing: 13.06.2012
(51) Int. Cl.: H05K 7/20

(54) **PUMPED LOOP COOLING SYSTEM**
KÜHLSYSTEM MIT GEPUMPTEM KREISLAUF
SYSTÈME DE REFROIDISSEMENT EN BOUCLE À POMPE

(30) Priority: 13.06.2011 US 201161496092 P
(43) Date of publication of application: 16.04.2014
(73) Proprietor: Parker-Hannifin Corporation, Cleveland, Ohio 44124-4141 (US)
(72) Inventor: SATHE, Abhijit, Fort Wayne, Indiana 46835 (US); GILL, Scott, Huntertown, Indiana 46748 (US)
(74) Representative: Belcher, Simon James
(86) International application number: PCT/US2012/042176
(87) International publication number: WO 2012/174062

(56) References cited:
- US-A- 5 285 347
- US-A- 6 073 454
- US-A1- 2005 259 397

## Description

The present invention relates to a cooling system for cooling heat-generating components, for example, electronics and/or other heat-generating components.

Power electronic devices, such as insulated gate bipolar transistors (IGBTs), silicon controlled rectifiers (SCRs), etc., continue to achieve higher power switching capacity in a smaller envelope. The amount of heat created by these devices continues to climb as well. Conventional cooling methods for the power electronics include using blowing air and/or circulating a water-based fluid through cold plates in thermal contact with the electronic device. A more recent cooling method utilizes a phase change fluid, or refrigerant, that evaporates to remove heat from an electronic device heat sink and condenses back to liquid state through a heat exchange process with a cold medium (air or water). Additionally, the components may be housed in a container and air-cooled by an HVAC system that cools the air in the container.

US-A-2005/025397 discloses a cooling system for a computer system which includes heat-generating central processor units which are fixed to cold plates. Coolant flows through the cold plates to absorb heat and then to a heat exchanger. The heat exchanger can be cooled by means of a refrigerant with a condenser. Additional components of the computer system are cooled by means of a stream of air which is made to flow over the components by means of fans. Cooled air can be used.

The present invention provides a pumped looped refrigerant cooling system as defined in claim 1.

The system can be used to cool power electronic components and peripheral electronic components that are housed within a container. The pumped loop cooling system has two branches through which refrigerant is pumped. In a first branch, refrigerant is pumped through cold plates that are in thermal contact with power-generating electronics. In a second branch, the refrigerant is pumped through an air chiller to cool the air inside the container, thereby air cooling the peripheral electronics contained therein. Advantageously, the two branches can share a single condenser located outside of the container for condensing the refrigerant pumped through the system.

The pumped loop system described herein can eliminate the need for a HVAC system to cool the air inside of the container and any heat-generating components therein. An HVAC system can have operating costs that are orders of magnitude higher than that of a pumped loop refrigerant cooling system. Accordingly, the pumped loop system described herein can be significantly less expensive to operate than a combined pumped loop/HVAC system.

The pumped-loop cooling system can include a container that houses a plurality of electronic components, in which the heat that is absorbed by the refrigerant is dissipated to an area outside of the container.

The invention also provides a method of cooling a plurality of first heat-generating components and second heat-generating components in a container, as defined in claim 15.

Embodiments of this invention will now be described in further detail with reference to the accompanying drawings, in which:
FIG. 1 is a schematic diagram of a first embodiment of a pumped loop cooling system in accordance with aspects of the invention; and
FIG. 2 is a schematic diagram of a second embodiment of a pumped loop cooling system in accordance with aspects of the invention.

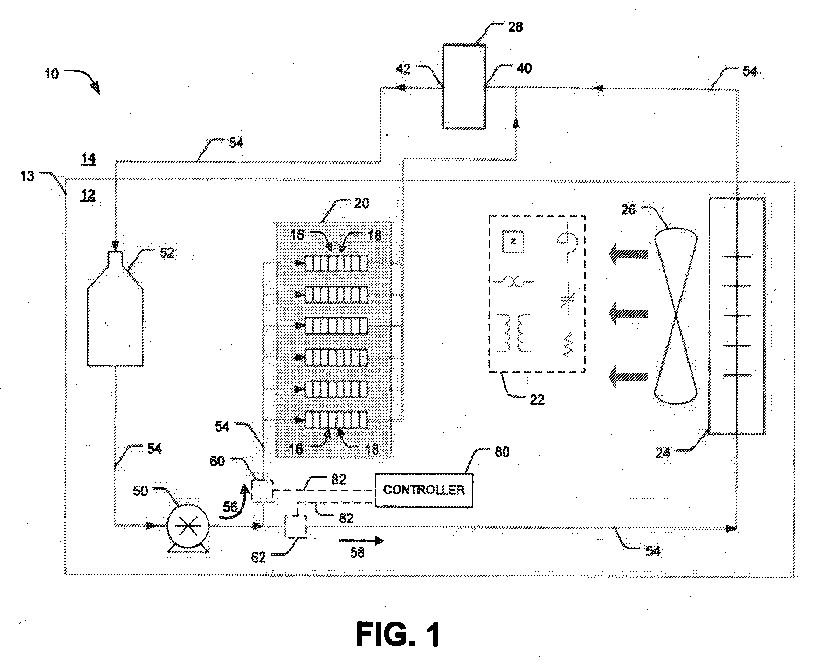

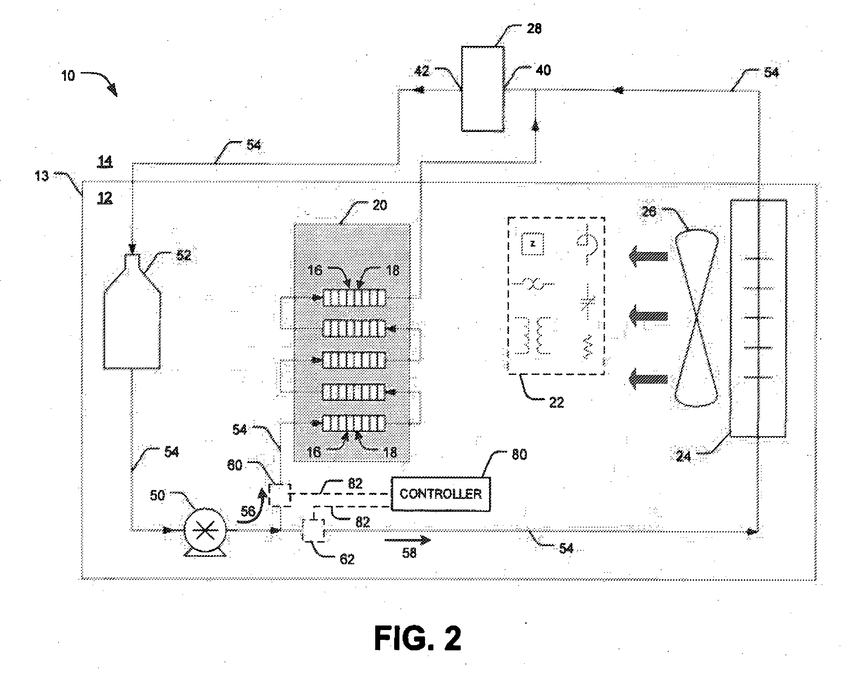

Referring to FIGS. 1 and 2, exemplary schematic diagrams of a pumped-loop system 10 for cooling heat-generating components are shown. In the illustrated embodiments, some components of the system 10 are disposed in a first environment 12 and some of the components of the system 10 are disposed in a second environment 14. The first environment 12 maybe a closed environment, e.g., the interior of a container 13 that houses electrical components, such as power-producing electronics and/or other electrical components, while the second environment 14 may be representative of an outdoor, ambient air environment. The environments 12 and 14 may be generally closed off from one another, e.g., such that the air inside of first environment 12 generally remains separate from air in the second environment 14.

As described in more detail below, a fluid is pumped through the system 10 to cool the heat-generating components by touch cooling and/or by air-cooling. The fluid may be a refrigerant such as a vaporizable dielectric refrigerant. Suitable refrigerants include, HFC-134a, HFO-1234yf, for example.

The first environment 12 contains one or more first heat-generating components 16. The first heat-generating components 16 can be power-generating electronic components, e.g., components 16 that have a heat dissipation rate of 1 kW or more. For example, the first heat-generating components 16 may be inverter drives, IGBT modules, or other high-heat generating components. The first heat-generating components 16 can be touch-cooled as described in more detail below.

The first heat-generating components 16 are in thermal contact with respective heat exchangers (also referred to as "cold plates") designated generally by reference numeral 18. The heat exchangers 18 include a passageway through which the refrigerant flows. By being in thermal contact with the first heat-generating components 16, the refrigerant flowing through the heat exchangers 18 absorbs the heat generated by the first heat-generating components 16. The first heat-generating components 16 and respective heat exchangers 18 may be disposed within a housing 20 located in the first environment 12, such as a cabinet.

The heat exchangers 18 may be arranged in parallel as shown in FIG. 1, or in series as shown in FIG. 2, or any combination of parallel and series. Although described primarily with respect to FIG. 1 in which the heat exchangers are arranged in parallel, it should be appreciated that the principles described herein are equally applicable to the system of FIG. 2 in which the heat exchangers are arranged in series or any embodiment having heat exchangers arranged in series and/or in parallel.

The system 10 also includes a plurality of second heat-generating components 22, which may be located in the first environment 12 as shown in the exemplary embodiment of FIG. 1. The second heat-generating components 22 dissipate heat to the air within the first environment 12. The second heat-generating components 22 may be low power heat-generating components. For example, the second heat-generating components 22 may be electrical components that produce less heat than the first heat-generating components 16, e.g., components that have a heat dissipation rate less than 1 kW. Due to the lower level of heat generation, the second heat-generating components 22 can be air-cooled components, e.g., electrical components that can be cooled by exposure to air. For example, the second heat-generating components 22 may be peripheral electronics such as transformers, resistors, chokes, diodes, capacitors, inductors, or other components that, etc.

The system 10 also includes a chiller 24 for air-cooling the second heat-generating components 22. The chiller absorbs heat from the air in the first environment 12, thereby cooling the air and the components contained therein. The chiller can be completely enclosed in the container such that it only receives and chills the air contained in the container. This can prevent dust particles and contaminants from entering the sealed container. The chiller also may be associated with a fan 26 for circulating the air within the first environment 12 to aid in the air cooling of the second heat-generating components 22. The fan 26 can be arranged so as to blow air cooled by the chiller 24 directly on the second heat-generating components 22 to facilitate the cooling.

The system 10 includes a condenser 28 for receiving and condensing the refrigerant from the heat exchangers 18 and the chiller 24. The condenser 28 receives refrigerant that has been at least partially vaporized by heat exchangers 18 and the chiller 24 through an inlet 40. The partially vaporized refrigerant is condensed to liquid form by the condenser and exits the condenser via a corresponding outlet 42. As shown in FIG. 1, the condenser 28 can be located in the second environment 14, e.g., outside of the container, and the heat may be dissipated from the system to the area outside of the first environment 12.

The condenser 28 is in fluid communication with a pump 50 such that the pump receives the refrigerant that has been condensed by the condenser prior to circulating the fluid to the heat exchangers 18 and the chiller 24.

The system 10 also can include a reservoir 52 for receiving refrigerant from the condenser 28 and for supplying the refrigerant to the pump 50. The reservoir can store excess refrigerant in the system, and any refrigerant that has not condensed in the condenser 28 can be condensed within the reservoir 52. As shown in FIG. 1, the pump and the reservoir may be disposed in the first environment 12, however, the pump and/or the reservoir can be disposed in the second environment 14, or in another environment.

As shown, the various components of the system can be coupled via conduits 54 with the heat exchangers 18 located in a first branch 56 of the system 10, and the chiller 24 located in a second branch 58 of the system. The pump circulates refrigerant through the first branch 56 and the second branch 58. Flow of refrigerant to the respective branches may be controlled by one or more flow restrictor. For example, as shown in FIG. 1, a first flow restrictor 60 can be disposed between the pump 50 and the heat exchangers 18 for controlling the flow of refrigerant to the first branch 56. A second flow restrictor 62 can be disposed between the pump 50 and the chiller 24 for controlling the flow of refrigerant to the first circuit 58. Additionally, flow restrictors can be incorporated in to control the flow of refrigerant to the individual heat exchanges, or groups of heat exchangers, e.g., if any of the heat exchangers are arranged in parallel as shown in FIG. 1. The flow restrictors may be fixed orifice flow restrictors or variable flow regulators. It is possible to use electronic or solenoid flow regulators.

The system 10 also can include a controller 80 for controlling the flow restrictors 60 and 62 via communication lines 82. The controller can be in communication with one or more pressure feedback devices, which may be incorporated within the flow restrictors 60 and 62. As the back pressure increases, the variable flow regulator closes the passage until the back pressure lowers to an acceptable level.

An exemplary method of cooling the electrical components will now be described with respect to FIG. 1 in which the heat exchangers 18 and the chiller 24 are in parallel to one another. Cooling of the first heat-generating components 16 can be achieved by pumping liquid refrigerant with the pump 50 through the first branch 56. Heat from the first heat-generating components 16 is absorbed by the refrigerant passing through the heat exchangers 18, which causes at least a portion of the refrigerant to evaporate. The refrigerant is then circulated from the heat exchangers 18 to the condenser 28 where the refrigerant condenses back to liquid form, thereby rejecting the heat to the second environment 14. The refrigerant is then circulated from the condenser 28 back to the pump 50, or, if the system 10 includes a reservoir 52, the refrigerant is circulated from the condenser 28 to the pump 50 after being accumulated in the reservoir 52. In this manner, the system 10 cools the first heat-generating components 18.

Cooling of the second heat-generating components 22 can be achieved by pumping liquid refrigerant through the second branch 58 with the pump 50. Heat from the air in the first environment 12 is absorbed by the refrigerant in the chiller 24, causing at least a portion of the refrigerant to evaporate. In this manner, the system 10 cools the air in the first environment 12. The cooled air can then be used to air cool the second heat-generating components 22. The refrigerant is then circulated from the chiller 24 to the condenser 28 where the refrigerant condenses back into liquid form, thereby rejecting the heat to the second environment 14. The refrigerant is then circulated from the condenser 28 back to the pump 50, or, if the system 10 includes a reservoir 52, the refrigerant is circulated from the condenser 28 to the pump 50 after being accumulated in the reservoir 52. As noted above, the blower 26 can be arranged so as to circulate the cooled air within the first environment 12 to facilitate the cooling of the second heat-generating components 22.

To the accomplishment of the foregoing and related ends, the invention comprises the features fully described herein and particularly pointed out in the claims. The description and the annexed drawings set forth in detail certain illustrative embodiments of the invention. These embodiments are indicative, however, of but a few of the various ways in which the principles of the invention may be employed. Other objects, advantages and novel features of the invention will become apparent from the detailed description of the invention when considered in conjunction with the drawings.

## Claims

1. A pumped-loop cooling system (10) comprising:
a plurality of first heat-generating components (16) and at least one heat exchanger (18) in thermal contact with the first heat-generating components for absorbing heat from the first heat-generating components via refrigerant flowing through the heat exchanger,
a plurality of second heat-generating components (22),
a chiller (24) for air-cooling the second heat-generating components,
a condenser (28) for receiving and condensing refrigerant received from the heat exchanger, and
a pump (50) for circulating refrigerant through the system, the pump receiving refrigerant that has been condensed by the condenser and pumping the refrigerant to the heat exchanger,
**characterised in that** the condenser (28) is also for receiving and condensing refrigerant received from the chiller (24), and the pump (50) is also for pumping the refrigerant to the chiller.

2. The system of claim 1, in which the first heat-generating components (16), the heat exchanger (18) and the second heat-generating components (22) are located in a first environment (12) and the condenser (28) dissipates heat absorbed by the refrigerant to a second environment (14).

3. The system of claim 2, in which the plurality of first heat-generating components (16) are disposed in a housing (13) within the first environment (12).

4. The system of claim 2 or claim 3, in which the pump (50) is located in the first environment.

5. The system of any one of claims 1 to 4, in which the heat exchanger (18) and the chiller (24) are arranged in parallel to one another.

6. The system of any one of claims 1 to 5, comprising plural heat exchangers (18) in thermal contact with respective first heat-generating components (16).

7. The system of claim 6, in which the plural heat exchangers (18) are arranged in parallel to one another.

8. The system of claim 6, in which the plural heat exchangers (18) are coupled to one another in series.

9. The system of any one of claims 1 to 8, further comprising a first flow restrictor (60, 62) for controlling flow of refrigerant to the heat exchanger (18) and/or to the chiller (24).

10. The system of any one of claims 1 to 8, further comprising a first flow restrictor (60) for controlling flow of refrigerant to the heat exchanger (18), and a second flow restrictor (62) for controlling the flow of refrigerant to the chiller (24).

11. The system of claim 10, in which the first flow restrictor (60) is disposed between the pump (50) and the heat exchanger (18), and second flow restrictor (62) is disposed between the pump (50) and the chiller (24).

12. The system of any one of claims 9 to 11, in which the or at least one of the flow restrictors (60, 62) is a variable flow restrictor.

13. The system of any one of claims 1 to 12, further comprising a reservoir (52) for receiving refrigerant from the condenser (28) and for supplying refrigerant to the pump (50).

14. The system of any one of claims 1 to 13, in which the plurality of first heat-generating components (16) comprise power-generating electronic components, and in which the plurality of second-heat generating components (22) comprise low-power electronic components.

15. A method of cooling a plurality of first heat-generating components and second heat-generating components in a container comprising:
cooling a plurality of first heat-generating components (16) in a container (13) by pumping refrigerant with a pump (50) through at least one heat exchanger (18) in thermal contact with the first heat-generating components to absorb the heat generated by the first heat-generating components,
cooling air in the container (13) by pumping refrigerant with the pump through a chiller (24) to absorb heat from the air in the container, thereby air-cooling a plurality of second heat-generating components (22) located in the container,
dissipating the heat absorbed by the refrigerant in the heat exchanger and the chiller, the heat dissipated via a condenser (28) to an area outside of the container, and
circulating the refrigerant from the condenser to the pump.

## Patentansprüche

1. Ein Kühlsystem (10) mit gepumptem Kreislauf, das umfasst:
eine Vielzahl erster wärmeerzeugender Komponenten (16) und wenigstens einen Wärmetauscher (18) im thermischen Kontakt mit den ersten wärmeerzeugenden Komponenten zur Aufnahme von Wärme von den ersten wärmeerzeugenden Komponenten über ein durch den Wärmetauscher fließendes Kältemittel,
eine Vielzahl zweiter wärmeerzeugender Komponenten (22),
einen Kühler (24) zum Luftkühlen der zweiten wärmeerzeugenden Komponenten,
einen Kondensator (28) zum Aufnehmen und Kondensieren von aus dem Wärmetauscher erhaltenem Kältemittel und
eine Pumpe (50) zum Umwälzen von Kältemittel in dem System, wobei die Pumpe Kältemittel erhält, welches von dem Kondensator kondensiert wurde, und das Kältemittel zu dem Wärmetauscher pumpt,
**dadurch gekennzeichnet, dass** der Kondensator (28) auch zum Aufnehmen und Kondensieren von aus dem Kühler (24) erhaltenem Kältemittel ist, und dass die Pumpe (50) auch zum Pumpen des Kältemittels zum Kühler ist.

2. Das System nach Anspruch 1, bei dem sich die ersten wärmeerzeugenden Komponenten (16), der Wärmetauscher (18) und die zweiten wärmeerzeugenden Komponenten (22) in einer ersten Umgebung (12) befinden und der Kondensator (28) durch das Kältemittel aufgenommene Wärme an eine zweite Umgebung (14) abgibt.

3. Das System nach Anspruch 2, bei dem die Vielzahl erster wärmeerzeugender Komponenten (16) in einem Gehäuse (13) innerhalb der ersten Umgebung (12) angeordnet ist.

4. Das System nach Anspruch 2 oder Anspruch 3, bei dem sich die Pumpe (50) in der ersten Umgebung befindet.

5. Das System nach einem der Ansprüche 1 bis 4, bei dem der Wärmetauscher (18) und der Kühler (24) parallel zueinander angeordnet sind.

6. Das System nach einem der Ansprüche 1 bis 5, welches eine Mehrzahl an Wärmetauschern (18) in thermischem Kontakt mit entsprechenden ersten wärmeerzeugenden Komponenten (16) umfasst.

7. Das System nach Anspruch 6, bei dem die Mehrzahl an Wärmetauschern (18) parallel zueinander angeordnet sind.

8. Das System nach Anspruch 6, bei dem die Mehrzahl an Wärmetauschern (18) in Serie zueinander geschaltet ist.

9. Das System nach einem der Ansprüche 1 bis 8, welches ferner einen ersten Strömungsbegrenzer (60, 62) zur Steuerung von Kühlmittelströmung zu dem Wärmetauscher (18) und/oder zu dem Kühler (24) umfasst.

10. Das System nach einem der Ansprüche 1 bis 8, welches ferner einen ersten Strömungsbegrenzer (60) zur Steuerung von Kühlmittelströmung zu dem Wärmetauscher (18) und einen zweiten Strömungsbegrenzer (62) zum Steuern von Kühlmittelströmung zu dem Kühler (24) umfasst.

11. Das System nach Anspruch 10, bei dem der erste Strömungsbegrenzer (60) zwischen der Pumpe (50) und dem Wärmetauscher (18) angeordnet ist, und der zweite Strömungsbegrenzer (62) zwischen der Pumpe (50) und dem Kühler (24) angeordnet ist.

12. Das System nach einem der Ansprüche 9 bis 11, bei dem der oder wenigstens einer der Strömungsbegrenzer (60, 62) ein variabler Strömungsbegrenzer ist.

13. Das System nach einem der Ansprüche 1 bis 12, welches ferner einen Sammelbehälter (52) zum Aufnehmen von Kühlmittel von dem Kondensator (28) und zum Liefern von Kühlmittel an die Pumpe (50) umfasst.

14. Das System nach einem der Ansprüche 1 bis 13, bei dem die Vielzahl erster wärmeerzeugender Komponenten (16) stromerzeugende elektronische Komponenten umfasst, und bei dem die Vielzahl zweiter wärmeerzeugender Komponenten (22) leistungsarme elektronische Komponenten umfasst.

15. Ein Verfahren zum Kühlen von einer Vielzahl erster wärmeerzeugender Komponenten und zweiter wärmeerzeugender Komponenten in einem Behälter, welches umfasst:
Kühlen einer Vielzahl erster wärmeerzeugender Komponenten (16) in einem Behälter (13) durch Pumpen von Kühlmittel mit einer Pumpe (50) durch wenigstens einen Wärmetauscher (18) in thermischem Kontakt mit den ersten wärmeerzeugenden Komponenten zum Aufnehmen von durch die ersten wärmeerzeugenden Komponenten erzeugter Wärme,
Kühlen von Luft in dem Behälter (13) durch Pumpen von Kühlmittel mit der Pumpe durch einen Kühler (24), um Wärme von der Luft in dem Behälter aufzunehmen, wodurch eine Vielzahl zweiter wärmeerzeugender Komponenten (22), die in dem Behälter angeordnet sind, luftgekühlt werden,
Abgeben der durch das Kühlmittel in dem Wärmetauscher und dem Kühler aufgenommenen Wärme, wobei die Wärme über einen Kondensator (28) an einen Bereich außerhalb des Behälters abgegeben wird, und
Umwälzen des Kühlmittels von dem Kondensator zu der Pumpe.

## Revendications

1. Système de refroidissement à boucle à pompage (10) comprenant :
une pluralité de premiers composants de génération de chaleur (16) et au moins un échangeur de chaleur (18) en contact thermique avec les premiers composants de génération de chaleur pour absorber la chaleur provenant des premiers composants de génération de chaleur par l'intermédiaire d'un fluide frigorigène s'écoulant à travers l'échangeur de chaleur,
une pluralité de deuxièmes composants de génération de chaleur (22),
un refroidisseur (24) pour le refroidissement à l'air des deuxièmes composants de génération de chaleur,
un condenseur (28) permettant de recevoir et de condenser le fluide frigorigène reçu à partir de l'échangeur de chaleur, et
une pompe (50) permettant la circulation du fluide frigorigène à travers le système, la pompe recevant un fluide frigorigène qui a été condensé par le condenseur et assurant le pompage du fluide frigorigène vers l'échangeur de chaleur,
**caractérisé en ce que** le condenseur (28) est configuré pour recevoir et condenser le fluide frigorigène reçu à partir du refroidisseur (24), et la pompe (50) est configuré pour pomper le fluide frigorigène vers le refroidisseur.

2. Système de la revendication 1, dans lequel les premiers composants de génération de chaleur (16), l'échangeur de chaleur (18) et les deuxièmes composants de génération de chaleur (22) sont situés dans un premier environnement (12) et le condenseur (28) dissipe de la chaleur absorbée par le fluide frigorigène dans un deuxième environnement (14).

3. Système de la revendication 2, dans lequel la pluralité de premiers composants de génération de chaleur (16) sont disposés dans un boîtier (13) à l'intérieur du premier environnement (12).

4. Système de la revendication 2 ou 3, dans lequel la pompe (50) est située dans le premier environnement.

5. Système de l'une quelconque des revendications 1 à 4, dans lequel l'échangeur de chaleur (18) et le refroidisseur (24) sont agencés en parallèle l'un à l'autre.

6. Système de l'une quelconque des revendications 1 à 5, comprenant plusieurs échangeurs de chaleur (18) en contact thermique avec des premiers composants de génération de chaleur (16) respectifs.

7. Système de la revendication 6, dans lequel les plusieurs échangeurs de chaleur (18) sont agencés en parallèle les uns aux autres.

8. Système de la revendication 6, dans lequel les plusieurs échangeurs de chaleur (18) sont couplés les uns aux autres en série.

9. Système de l'une quelconque des revendications 1 à 8, comprenant en outre un premier réducteur de débit (60, 62) permettant de commander l'écoulement du fluide frigorigène vers l'échangeur de chaleur (18) et/ou vers le refroidisseur (24).

10. Système de l'une quelconque des revendications 1 à 8, comprenant en outre un premier réducteur de débit (60) permettant de commander l'écoulement du fluide frigorigène vers l'échangeur de chaleur (18), et un deuxième réducteur de débit (62) permettant de commander l'écoulement du fluide frigorigène vers le refroidisseur (24).

11. Système de la revendication 10, dans lequel le premier réducteur de débit (60) est disposé entre la pompe (50) et l'échangeur de chaleur (18), et un deuxième réducteur de débit (62) est disposé entre la pompe (50) et le refroidisseur (24).

12. Système de l'une quelconque des revendications 9 à 11, dans lequel le réducteur de débit ou au moins l'un des réducteurs de débit (60, 62) est un réducteur de débit variable.

13. Système de l'une quelconque des revendications 1 à 12, comprenant en outre un réservoir (52) permettant de recevoir le fluide frigorigène provenant du condenseur (28) et permettant d'alimenter la pompe (50) en fluide frigorigène.

14. Système de l'une quelconque des revendications 1 à 13, dans lequel la pluralité de premiers composants de génération de chaleur (16) comprennent des composants électroniques de génération de puissance, et dans lequel la pluralité de deuxièmes composants de génération de chaleur (22) comprennent des composants électroniques à faible puissance.

15. Procédé de refroidissement d'une pluralité de premiers composants de génération de chaleur et de deuxièmes composants de génération de chaleur dans un récipient comprenant le fait :
de refroidir une pluralité de premiers composants de génération de chaleur (16) dans un récipient (13) par le pompage d'un fluide frigorigène avec une pompe (50) à travers au moins un échangeur de chaleur (18) en contact thermique avec les premiers composants de génération de chaleur pour absorber la chaleur générée par les premiers composants de génération de chaleur,
de refroidir l'air dans le récipient (13) par le pompage du fluide frigorigène avec la pompe à travers un refroidisseur (24) pour absorber la chaleur de l'air dans le récipient, ce qui permet le refroidissement à l'air d'une pluralité de deuxièmes composants de génération de chaleur (22) situés dans le récipient,
de dissiper la chaleur absorbée par le fluide frigorigène dans l'échangeur de chaleur et le refroidisseur, la chaleur dissipée par l'intermédiaire d'un condenseur (28) dans une zone à l'extérieur du récipient, et
de faire circuler le fluide frigorigène du condenseur vers la pompe.
